Europäisches Patentamt

(19) European Patent Office

Office européen des brevets

(11) Publication number: **0 004 375**
**B1**

(12) **EUROPEAN PATENT SPECIFICATION**

(45) Date of publication of patent specification: **01.12.82** (51) Int. Cl.³: **G 03 D 5/06**

(21) Application number: **79100855.0**

(22) Date of filing: **21.03.79**

(54) Process for pre-conditioning a film and apparatus for carrying out the process.

(30) Priority: **23.03.78 US 889420**

(43) Date of publication of application:
**03.10.79 Bulletin 79/20**

(45) Publication of the grant of the patent:
**01.12.82 Bulletin 82/48**

(84) Designated Contracting States:
**BE DE FR GB**

(56) References cited:
**FR - A - 692 800**
**FR - A - 1 370 612**
**GB - A - 556 631**
**US - A - 2 305 011**

(73) Proprietor: **E.I. DU PONT DE NEMOURS AND COMPANY**
**Legal Department 1007 Market Street**
**Wilmington Delaware 19898 (US)**

(72) Inventor: **Bratt, Martin Daniel**
**46 Tuscarora Circle**
**Old Bridge New Jersey 08857 (US)**
Inventor: **Oakley, John Francis**
**438 East King St.**
**Lancaster, PA 17602 (US)**

(74) Representative: **von Kreisler, Alek, Dipl.-Chem. et al,**
**Deichmannhaus am Hauptbahnhof**
**D-5000 Köln 1 (DE)**

Courier Press, Leamington Spa, England.

# Process for pre-conditioning a film and apparatus for carrying out the process

## Technical field

This invention relates generally to the processing of lithographic film and, more particularly, to a pre-conditioning of such film before its development.

## Background

In the graphic arts industry, and particularly in lithography, printing plates are usually imaged by exposing them through a film containing a line or half-tone image. At the outset, the original material or "copy" may be in the form of a continuous tone photograph, drawing or type proof. This is then reduced to a black and white transparency of the correct size using a camera or scanner and, during this step, continuous tone images may be converted to half-tone. This transparency, however, is seldom in a form suitable for the exposure of a plate and a contact or first generation copy is made, for example, to combine line and half-tone films in register, to produce a single film from stripped flats, to strengthen half-tone dots or to make spreads or chokes. The first generation copy may then be printed on another film in contact to give a second generation copy, and this even to a third generation before a film suitable for use in plate exposure is obtained.

In the contact printing operation, a target film is placed over a sheet of unexposed film in a vacuum frame. After vacuum has been applied and the films are in good contact, the film is exposed and then processed. Contact printing is usually carried out with silver halide films that can be either negative or positive working. However, photosensitive films, either photohardenable or photosolubilizable, can also be used. They consist typically of a transparent polyethylene terephthalate support, on one side of which is an opaque photosensitive layer covered by a thin oxygen impermeable barrier layer. Actinic light forms relatively soluble and insoluble regions in the photosensitive layer and the soluble regions can then be washed out in a suitable solvent to leave a relief image of the target. It was found in practice that the use of such films often results in an unacceptably high level of pin holes in opaque areas of copies which resulted from residual opaque specks in supposedly clear areas of the preceding generation.

Pinholes in opaque areas result from dirt carried by or pressed into the surface of soluble regions of the preceding generation, for example, during vacuum draw down. Such dirt can retard the penetration of developer in its immediate area and result in a residual speck of underdeveloped photosensitive material which will copy as a pinhole.

## Prior art

GB—A 556 631 teaches a method of forming a second record and a picture record in sound and picture zones respectively which comprises coating one zone with lacquer, processing the other zone with one or more solutions in which the lacquer coating is insoluble, removing the coating with a lacquer solvent, processing the first zone with one or more liquids the first of which is immiscible with said solvent and intermediate said two last steps removing said solvent with a solvent miscible with said solvent and also with said one or first liquid. This method and apparatus differ significantly from the features and goals of this invention, especially as it permits the film to meander prior to its entry into the developing step, so that the opportunity is permitted to have dirt again deposited on the film.

US—A 2 305 011 shows an apparatus for making motion pictures by etching off a part of the gelatin with etching liquid to leave images in relief, involving a tendency for gelatinous pellicles to bridge the sprocket holes, the combination of cleaning means for breaking said gelatinous pellicles out of the sprocket holes, said means acting upon the sprocket-hole zone of the film without corresponding action on the picture zone, and means for rinsing away the gelatinous material cleaned out of the sprocket holes. The features and goals of this prior art are also quite different from that of this invention. The prior art does not show or recommend to advance the exposed film through the preconditioning zone directly to the developing zone and subjecting the surface of the film and the preconditioning zone to shearing forces by two rolls-rotating in the same direction as the film is transported at different surface speeds.

## Disclosure of invention

It has now been found that the difficulties of pin holes in opaque areas resulting from dirt carried by or pressed into the surface of soluble regions of the preceding generation can be reduced or avoided at all by a process for pre-conditioning a film before developing it in order to remove dirt from its surface, the film including a photosensitive layer having, after exposure, an image of regions that are soluble and insoluble in a developing solution, characterized by the steps of advancing the exposed film through a pre-conditioning zone directly to the developing zone and by subjecting the surface of the film in the pre-conditioning zone to shearing forces by two rolls rotating in the same direction as the film is transported at different surface speeds while simultaneously flooding it with a flushing liquid, said flushing liquid being miscible with the developing solution but incapable of dissolving any portion of said layer.

In a preferred embodiment, said film has an overcoat on said photosensitive layer and the flushing liquid is a solvent for the overcoat. More preferred is a process where said overcoat is soluble in water and wherein flooding of the film is done with water while scrubbing at least part of said overcoat from the film.

A further embodiment of this invention is an apparatus designed for carrying out the inventive process. This apparatus for developing film in a preconditioner comprises: a scrub roll, a second roll in engagement with the scrub roll for transporting a film to be developed, a conduit positioned near and provided with perforations directly at said scrub roll for directing a flushing fluid onto the surface of the scrub roll, a source of flushing liquid connected to said conduit, and drive means coupled to said rolls for their concurrent rotation in the same direction as the film is transported but at different surface speeds.

Further preferred embodiments are subject of subclaims 7 to 11.

Description of drawings

Figure 1 is a side elevation of an apparatus for developing film, parts having been shown in section to reveal constructional details of the pre-conditioner.

Figure 2 is a schematic illustration of the drive system associated with the driven rolls of Figure 1.

Description of apparatus

The illustrated apparatus has a pre-conditioner unit 10 attached to a developing unit 12 which, in turn, is connected to a rinsing unit 14. After development, a rinsed film is fed through a dryer. Details of the units 12, 14 and their operation have been described in DE—A—27 02 335, published August 11, 1977.

Unit 10 includes a transport roll 16 and a surface driven pinch roll 18 between which a film with an exposed upper surface is fed to the nip between roll 16 and a scrub roll 20. Rolls 16, 18, 20 are journalled in upright plates 22 located at the ends of a pan 24. Rolls 16, 18 are covered with hard layers of a synthetic rubber and roll 20 with a layer of spongy material such as foam rubber or polyurethane.

Above scrub roll 20, there is a conduit 26 connected through a hose 28 to the outlet of a pump 30 that circulates rinse water to unit 14. In the bottom of conduit 26, there is a line of perforations through which water drips to the spongy surface of scrub roll 20. Water from pan 24 is recirculated through a hose 32 to the suction side of pump 30. Flushing liquids other than water may be used if they are miscible with the developing solvent but incapable of dissolving any portion of the photosensitive layer. Furthermore, the flushing liquid can be recirculated through hoses and pumps that are independent of the units 12, 14.

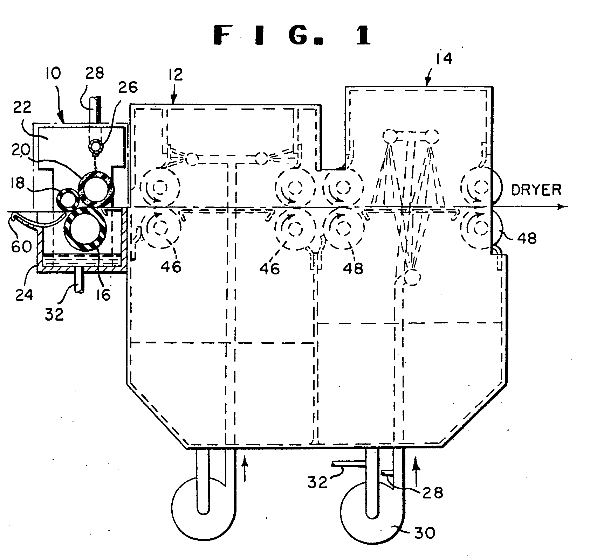

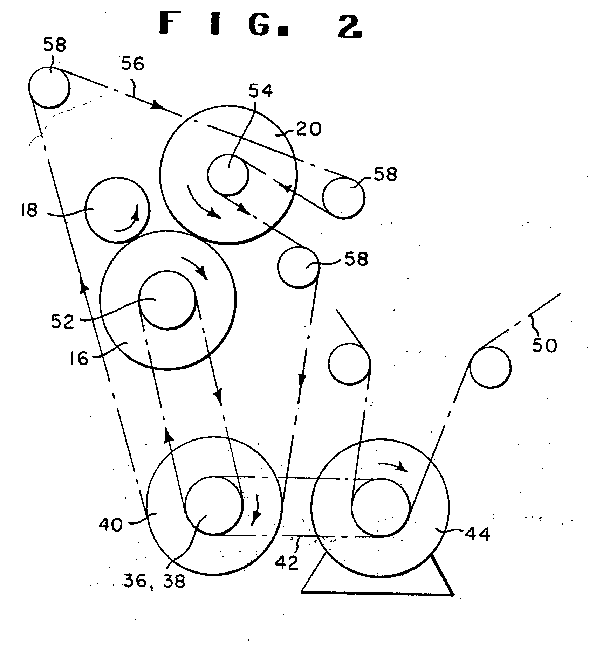

As shown in Figure 2, the drive system for pre-conditioner 10 includes interconnected sprocket wheels 36, 38, 40. Sprocket wheel 36 is driven through a chain 42 by a motor 44. Motor 44 is coupled to feed rolls 46, 48 (Figure 1) for developing and rinsing units 12, 14 through a chain 50. Sprocket wheel 38 has the same number of teeth as a sprocket wheel 52 that is connected to transport roll 16. Wheel 38 drives roll 16 at process speed, i.e., the surface speed of roll 16 is the same as the surface speed of feed rolls 46, 48. Sprocket wheel 40 is coupled to a sprocket wheel 54 through a chain 56 that also passes over idler sprockets 58. Wheel 54 is connected to scrub roll 20 and has substantially fewer teeth than wheel 40, i.e., the surface speed of scrub roll 20 exceeds process speed.

In operation, an exposed film that has a photosensitive layer on a support is placed on a tray 60 of spaced wires and inserted into unit 10. The leading edge of tray 60 is directed downwardly and the trailing edge is bent upwardly toward the nip between rolls 16, 18. This configuration of the tray directs an inserted film to rolls 16, 18 and the latter advance the film past scrub roll 20 and another wire tray to the feed rolls 46 in developing unit 12. Thereafter, the film advances in a straight line path through units 12, 14 and the associated dryer.

In unit 10, flushing liquid drips from conduit 26 onto the spongy surface of scrub roll 20. Liquid squeezed from roll 20 floods the upper surface of the film. As noted, the surface speed of roll 20 exceeds that of roll 16. Thus, roll 20 moves co-current with respect to roll 16 and the advancing film. Such relative movement yields a scrubbing and shearing action simultaneously with the flooding of the film surface. The flushing liquid displaces and flushes dirt which would retard penetration of the photosensitive layer by the developer solution or solvent.

Where the term "dirt" is used herein, it refers to any foreign matter that retards or interferes with development and includes materials that are transparent or opaque to actinic radiation and soluble or insoluble in the processing liquids.

A developing solution is distributed over the surface of the film in unit 12 and rinse water is sprayed on the developed film in unit 14. These liquids and the mechanical spray action in unit 14 soften and permit removal of the soluble regions of the film.

Description of process

As is apparent from the foregoing, a known process involves the steps of exposing a film including a photosensitive layer to actinic light and then advancing it through a pre-conditioning zone to developing, rinsing and drying steps.

Where used herein, the term "photosensitive layer" applies to a layer of either a positive or negative working photohardenable or photosolubilizable composition. A photohardenable composition is one that becomes insoluble in regions exposed to actinic radiation and remains soluble in unexposed regions, thus providing a negative working system. Typical photohardenable compositions have been disclosed in BE—A—No. 848,409, granted May 17, 1977. A positive working photohardenable composition that is photopolymerizable and comprises a compound containing a dinitroso group which is a non-inhibitor of free radical polymerization and is photochemically converted by ultraviolet (UV) radiation (2000—3800A) to an inhibitor of free radical polymerization has been disclosed by Nebe in U.S.—A—4,029,505. The regions imagewise expose to UV radiation (2000—3800A) remain soluble, whereas the regions originally unexposed become insoluble when exposed to actinic radiation (>3800Å) that activates the free radical generating system but does not convert the nitroso compound to an inhibitor of free radical polymerization. A photosolubilizable composition is one that becomes soluble in exposed regions and remains insoluble in unexposed regions, thus providing a positive working system. Typical photosolubilizable compositions have been disclosed by Roos in U.S.—A—3,837,860.

Referring to the drawings, the surface of roll 16 contacted by the exposed film presents a pre-conditioning zone in which the film is flooded with flushing liquid squeezed from the spongy surface of roll 20 and scrubbed by the co-current, shearing movement of roll 20 relative to the film. The transport speed of the film is governed by the surface speed of roll 16. The scrubbing, shearing action along with simultaneous flooding of the film surface with flushing liquid removes most of any dust or dirt previously carried by or embedded in the surface of the film. Where the film surface is provided with an overcoat on the photosensitive layer, the flushing liquid used is a solvent for the overcoat layer. Passage of film having an overcoat through the pre-conditioning cycle than results in removal of at least a partial thickness of the overcoat. This is the best mode contemplated by applicants. From the pre-conditioning zone, the film is advanced directly through developing and rinsing steps in units 12, 14 to a dryer.

In the enclosure of unit 12, a developing solution or solvent for the soluble regions of the imagewise exposed film is pumped through spray bars onto the upper feed rolls and flows downwardly to and floods the scrubbed surface of the film. Flexible wipers engage the rolls to prevent escape of the developing solution to surfaces of the film other than the transient area between the inlet and outlet rolls 46. Thus, developing time is accurately controlled by and dependent on process speed. The developing solution softens and thereby facilitates removal of residual overcoat and soluble regions of the photosensitive layer.

From the developing step, the film advances to and through the rinsing step in the enclosure for unit 14 to a dryer. In the rinsing step, any softened or loose material resulting from the developer action is dislodged and flushed from the film.

An apparatus of the type shown in the drawings was used in comparative tests of the process. In these tests, the surface speed of scrub roll 20 was five times the surface speed of transport roll 16. The developing agent was an aqueous solution of an alkali carbonate and bicarbonate having a pH of about 11.

Lithographic film was prepared for the tests by coating a 0.1 mm (0.004 inch) thick film or base of polyethylene terephthalate with a subbing layer, a 0.005 mm (0.0002 inch) thick negative working photohardenable layer and an overcoat layer. The subbing layer is a polymer layer chosen to provide adhesion between the base and the photohardenable layer. The photohardenable layer, which is insoluble in water, can be developed with aqueous alkali, no organic solvent being necessary. It contains dispersed carbon black and has an optical density greater than 3.0 in the 300—500 nanometer region. The overcoat solution was applied with a 0.05 mm (0.002 inch) doctor blade and had a formulation in grams as follows:

| | |
|---|---|
| polyvinyl alcohol | 2.25 |
| distilled water | 122.50 |
| polyoxyethylene surfactant | 0.45 |
| ethyl "Cellosolve" | 2.50 |
| ethyl alcohol | 2.50 |
| colloidal silica (30% soln.) | 2.70 |

The dried overcoat had a coating weight of 10.0 mg/dm$^2$ and was soluble in water and in the aqueous alkaline developing solution.

The overcoated test sample was drawn down in a standard (nuArc®) vacuum frame for 5 minutes in emulsion-to-emulsion contact with a half-tone target bearing large opaque areas. The target was a silver image transparency with considerable room dirt on the emulsion side. The sample was then exposed through the target by a Sylvania BRH lamp (1000 watt, tungsten-iodide) for 20 seconds; the lamp was at a distance of 152.5 cm from the element. The exposed sample was cut in half. One half of the sample was processed in the developing apparatus shown in Figure 1 at a film speed of 3.66 m/min (12 fpm), while the other half of the sample was processed in the same apparatus, but with the pre-conditioner removed, at a film speed of 3.05 m/min (10 fpm) to yield two first generation films. The dust speck defect is difficult to see at this point but is more apparent when seen as a pinhole in the next generation.

Another negative working film sample was then drawn down in emulsion-to-emulsion contact and exposed through the first generation films prepared above, the first generation films being placed side-by-side over the sample, using the draw down and exposure conditions described above. The sample was processed in the apparatus of Figure 1 at a film speed of 12 fpm 3.66 m/min (12 fpm) to yield a second generation film. The pinholes were counted in the opaque areas in 40 fields of view (approximately 1 square cm total) of a microscope having a magnification power of 100.

For the first generation film that was pre-conditioned, the second generation film had 15 pinholes. For the first generation film that was not pre-conditioned, the second generation film had 113 pinholes.

## Claims

1. A process for pre-conditioning a film before developing it in order to remove dirt from its surface, the film including a photosensitive layer having, after exposure, an image of regions that are soluble and insoluble in a developing solution, characterized by the steps of advancing the exposed film through a pre-conditioning zone directly to the developing zone and by subjecting the surface of the film in the pre-conditioning zone to shearing forces by two rolls rotating in the same direction as the film is transported at different surface speeds while simultaneously flooding it with a flushing liquid, said flushing liquid being miscible with the developing solution but incapable of dissolving any portion of said layer.

2. The process of Claim 1, wherein said film has an overcoat on said photosensitive layer and the flushing liquid is a solvent for the overcoat.

3. The process of Claim 2, wherein the overcoat is soluble in water and wherein flooding of the film is done with water while scrubbing at least part of said overcoat from the film.

4. The process of Claim 3, wherein said film is advanced through the pre-conditioning zone at process speed and scrubbed by engagement with a roll having a wet spongy surface and a surface speed in excess of the process speed.

5. The process of Claim 4, wherein the water is applied directly to the spongy surface of the scrub roll.

6. An apparatus designed for carrying out the process defined in Claims 1 to 5 comprising: a scrub roll (20) a second roll (16) in engagement with the scrub roll for transporting a film to be developed, a conduit (26) positioned near and provided with perforations directly at said scrub roll (20) for directing a flushing fluid onto the surface of the scrub roll (20), a source of flushing liquid connected to said conduit (26), and drive means (44, 56) coupled to said rolls (16, 20) for their concurrent rotation in the same direction as the film is transported but at different surface speeds.

7. The apparatus according to Claim 6, wherein said scrub roll (20) is above the transporting roll (16) and has a spongy surface thereon.

8. The apparatus of Claim 6 or 7, wherein is provided a pinch roll (18) in engagement with and driven by said transporting roll (16) for preventing relative movement of film with respect to the transporting roll (16).

9. An apparatus designed for carrying out the process defined in Claims 1 to 5 including an enclosure (12, 14) for developing film, speed rolls (46, 48) for advancing film to and from the enclosure and drive means (44, 50) coupled to said speed rolls for their rotation at process speed, a pre-conditioner (10) comprising transport (16) and scrub roll (20) positioned adjacent said enclosure (12, 14), a conduit (26) located near and provided with perforations directed at said scrub roll (20) and a source of flushing liquid connected to said conduit, said scrub roll (20) being in engagement with said transport roll (16) and coupled to said drive means (44) for concurrent rotation at a surface speed greater than transport speed, said transport roll (16) being coupled to the drive means for rotation of its surface at process speed.

10. An apparatus of Claim 9 wherein said scrub roll (20) is above the transport roll (16) and has a surface comprised of a layer of spongy material.

11. An apparatus of Claims 9 or 10, wherein is provided a pinch roll (18) acting in engagement with and driven by said transport roll (16) to constrain forward movement of the film to the surface speed of the transport roll (16).

## Patentansprüche

1. Verfahren zur Vorbehandlung eines Films vor der Entwicklung zur Entfernung des Schmutzes von seiner Oberfläche, wobei der Film eine lichtempfindliche Schicht enthält, die nach der Belichtung ein Bild aus in einer Entwicklerlösung löslichen und unlöslichen Bereichen besitzt, dadurch gekennzeichnet, daß der belichtete Film durch eine Vorbehandlungszone unmittelbar in die Entwicklungszone fortbewegt und die Oberfläche des Films in der Vorbehandlungszone mit Hilfe zweier Walzen, die sich in der Filmtransportrichtung mit verschiedener Oberflächengeschwindigkeit drehen, Scherkräften ausgesetzt wird, wobei sie gleichzeitig mit einer Spülflüssigkeit bespült werden, die mit der Entwicklerlösung mischbar, jedoch nicht zur Auflösung irgendwelcher Teile der Schicht befähigt ist.

2. Verfahren nach Anspruch 1, dadurch gekennzeichnet, daß der Film einen Überzug auf der lichtempfindlichen Schicht besitzt und die Spülflüssigkeit ein Lösungsmittel für diesen Überzug ist.

3. Verfahren nach Anspruch 2, dadurch gekennzeichnet, daß der Überzug in Wasser löslich ist und das Bespülen mit Wasser durchgeführt, wobei mindestens ein Teil des Überzugs von dem Film abgeschrubbt wird.

4. Verfahren nach Anspruch 3, dadurch gekennzeichnet, daß der Film durch die Vorbehandlungszone mit der Verarbeitungsgeschwindigkeit fortbewegt, wird und durch Anschmiegen an eine Walze mit einer nassen, schwammigen Oberfläche mit größerer Oberflächengeschwindigkeit als der Verarbeitungsgeschwindigkeit geschrubbt wird.

5. Verfahren nach Anspruch 4, dadurch gekennzeichnet, daß das Wasser unmittelbar auf die schwammige Oberfläche der Schrubbwalze aufgebracht wird.

6. Apparatur zur Durchführung des Verfahrens nach Anspruch 1 bis 5, umfassend eine Schrubbwalze (20), eine zweite Walze (16) in Berührung mit der Schrubbwalze zum Transport des zu entwickelnden Films, eine Rohrleitung (26), die in der Nähe der Schrubbwalze angeordnet und mit Öffnungen unmittelbar an der Schrubbwalze (20) versehen ist, um eine Spülflüssigkeit auf die Oberfläche der Schrubbwalze (20) zu richten, eine Quelle für die Spülflüssigkeit, die mit der Rohrleitung (26) verbunden ist, sowie Antriebsvorrichtungen (44, 56), die mit den Walzen (16, 20) gekoppelt sind und deren gleichsinnige Drehung in Filmtransportrichtung, jedoch mit verschiedenen Oberflächengeschwindigkeiten, bewirken.

7. Apparatur nach Anspruch 6, dadurch gekennzeichnet, daß die Schrubbwalze (20) sich oberhalb der Transportwalze (16) befindet und eine schwammige Oberfläche besitzt.

8. Apparatur nach Anspruch 6 oder 7, dadurch gekennzeichnet, daß sie weiterhin eine Anklemmwalze (18) in anschmiegender Berührung mit der Transportwalze (16) und durch diese angetrieben umfaßt, die eine Relativbewegung des Films zu der Transportwalze (16) verhindert.

9. Apparatur zur Durchführung des Verfahrens nach Anspruch 1 bis 5, umfassend eine Umhüllung (12, 14) für die Filmentwicklung, Geschwindigkeitswalzen (46, 48) zur Fortbewegung des Films in die Umhüllung hinein und aus dieser heraus sowie Antriebsvorrichtungen (44, 50), die mit den Geschwindigkeitswalzen gekoppelt sind und deren Drehung mit der Verarbeitungsgeschwindigkeit bewirken, eine Vorbehandlungskammer (10), die die Transportwalze (16) und die Schrubbwalze (20) enthält und der Umhüllung (12, 14) unmittelbar benachbart ist, eine Rohrleitung (26), die in der Nähe der Schrubbwalze (20) angeordnet und mit auf diese gerichteten Öffnungen versehen ist, und eine mit dieser Rohrleitung verbundene Quelle für die Spülflüssigkeit, wobei die Schrubbwalze (20) die Transportwalze (16) berührt und mit der Antriebsvorrichtung (44) gekoppelt ist, die eine gleichsinnige Drehung mit größerer Oberflächengeschwindigkeit als der Verarbeitungsgeschwindigkeit bewirkt, und die Transportwalze (16) mit der Antriebsvorrichtung zur Drehung ihrer Oberfläche mit Verarbeitungsgeschwindigkeit gekoppelt ist.

10. Apparatur nach Anspruch 9, dadurch gekennzeichnet, daß die Schrubbwalze (20) sich oberhalb der Transportwalze (16) befindet und eine aus einer Schicht eines schwammigen Materials bestehende Oberfläche besitzt.

11. Apparatur nach Anspruch 9 oder 10, dadurch gekennzeichnet, daß sie weiterhin eine Anklemmwalze (18) in anschmiegender Berührung mit der Transportwalze (16) und durch diese angetrieben umfaßt, die dem Film eine Vorwärtsbewegung mit der Oberflächengeschwindigkeit der Transportwalze (16) aufzwingt.

**Revendications**

1. Procédé de prétraitement d'une pellicule avant son développement afin de débarrasser sa surface de souillures, la pellicule comprenant une couche photsensible portant, après exposition, une image de régions qui sont solubles et insolubles dans une solution de développement, caractérisé en ce qu'on fait avancer la pellicule exposée, à travers une zone de prétraitement, directement à la zone de développement et l'on soumet la surface de la pellicule dans la zone de prétraitement à des forces de cisaillement au moyen de deux rouleaux tournant dans le même sens que le défilement de la pellicule, à des vitesses circonférentielles différentes, tout en l'inondant simultanément avec un liquide de lavage miscible avec la solution de développement mais inapte à dissoudre toute portion de ladite couche.

2. Procédé selon la revendication 1, dans lequel ladite pellicule a un sur-revêtement pardessus ladite couche photosensible et le liquide de lavage est un solvant pour le sur-revêtement.

3. Procédé selon la revendication 2, dans lequel le sur-revêtement est soluble dans l'eau et dans lequel on effectue l'inondation de la pellicule avec de l'eau tout en enlevant par lavage une partie au moins dudit sur-revêtement de la pellicule.

4. Procédé selon la revendication 3, dans lequel on fait avancer ladite pellicule à travers la zone de prétraitement à vitesse de traitement et on la nettoie par l'action d'un rouleau présentant une surface spongieuse humide et animé d'une vitesse circonférentielle supérieure à la vitesse de traitement.

5. Procédé selon la revendication 4, dans lequel on applique l'eau directement à la surface spongieuse du rouleau nettoyeur.

6. Un appareil conçu pour mettre en oeuvre le procédé selon les revendications 1 à 5, comportant: un rouleau nettoyeur (20), un deuxième rouleau (16) en prise avec le rouleau nettoyeur pour faire défiler une pellicule à développer, un conduit (26) placé à proximité dudit rouleau nettoyeur (20) et muni de perforations situées directement au droit de celui-ci pour diriger un fluide de lavage sur la surface du rouleau nettoyeur (20), une source de liquide de lavage reliée audit conduit (26), et des moyens d'entraînement (44, 56) accouplés auxdits rouleaux (16, 20) pour les faire tourner conjointement dans le même sens que le défilement de la pellicule mais à des vitesses circonférentielles différentes.

7. Appareil selon la revendication 6, dans lequel ledit rouleau nettoyeur (20) est situé au-dessus du rouleau d'entraînement (16) et porte une surface spongieuse.

8. Appareil selon la revendication 6 ou 7, dans lequel est prévu un rouleau presseur (18) en prise avec ledit rouleau d'entraînement (16) en entraîné par celui-ci pour s'opposer au déplacement relatif de la pellicule par rapport au rouleau d'entraînement (16).

9. Appareil conçu pour mettre en oeuvre le procédé selon les revendications 1 à 5, comportant une enceinte (12, 14) de développement de pellicule, des rouleaux de vitesse (46, 48) propres à amener de la pellicule à l'enceinte et à l'en extraire et des moyens d'entraînement (44, 50) accouplés auxdits rouleaux de vitesse pour tourner à vitesse de traitement, un pré-traiteur (10) comprenant un rouleau d'entraînement (16) et de nettoyage (20) disposé à proximité de ladite enceinte (12, 14), un conduit (26) sité au voisinage dudit rouleau nettoyeur (20) et pourvu de perforations dirigées sur celui-ci, et une source de liquide de lavage reliée audit conduit, ledit rouleau nettoyeur (20) étant en prise avec ledit rouleau d'entraînement (16) et accouplé auxdits moyens d'entraînement (44) de façon à tourner conjointement à une vitesse circonférentielle supérieure à la vitesse d'entraînement, ledit rouleau d'entraînement (16) étant accouplé aux moyens d'entraînement de façon que sa surface tourne à la vitesse de traitement.

10. Appareil selon la revendication 9, dans lequel ledit rouleau nettoyeur (20) est situé au-dessus de rouleau d'entraînement (16) et présente une surface formée d'une couche de matière spongieuse.

11. Appareil selon la revendication 9 ou 10, dans lequel est prévu un rouleau presseur (18) agissant en prise avec ledit rouleau d'entraînement (16) et entraîné par celui-ci pour contraindre la pellicule à avancer à la vitesse circonférentielle du rouleau d'entraînement (16).

# F I G. 1

F I G. 2